(19) Europäisches Patentamt / European Patent Office / Office européen des brevets

(11) **EP 1 670 860 B1**

(12) **EUROPEAN PATENT SPECIFICATION**

(45) Date of publication and mention of the grant of the patent:
**04.04.2007 Bulletin 2007/14**

(51) Int Cl.:
**C08L 63/10** (2006.01)  **C08G 59/30** (2006.01)
**C08G 59/32** (2006.01)  **C09K 21/14** (2006.01)

(21) Application number: **04783699.4**

(22) Date of filing: **08.09.2004**

(86) International application number:
**PCT/US2004/029566**

(87) International publication number:
**WO 2005/040277 (06.05.2005 Gazette 2005/18)**

(54) **FLAME RETARDANT EPOXY PREPREGS, LAMINATES, AND PRINTED WIRING BOARDS OF ENHANCED THERMAL STABILITY**

FLAMMWIDRIGE EPOXYPREPREGS, LAMINATE UND LEITERPLATTEN MIT VERBESSERTER WÄRMESTABILITÄT

PREIMPREGNES EN RESINE EPOXYDE IGNIFUGES, LAMINES, ET CARTES DE CIRCUITS IMPRIMES PRESENTANT UNE STABILITE THERMIQUE AMELIOREE

(84) Designated Contracting States:
**AT BE BG CH CY CZ DE DK EE ES FI FR GB GR HU IE IT LI LU MC NL PL PT RO SE SI SK TR**

(30) Priority: **01.10.2003  US 678019**

(43) Date of publication of application:
**21.06.2006  Bulletin 2006/25**

(73) Proprietor: **ALBEMARLE CORPORATION**
**Baton Rouge,**
**Louisiana 70801 (US)**

(72) Inventors:
• **RANKEN, F., Paul**
 **Baton Rouge, LA 70810 (US)**
• **HERBIET, Rene, G., E.**
 **B-4700 Eupen (BE)**

(74) Representative: **UEXKÜLL & STOLBERG**
 **Patentanwälte**
 **Beselerstrasse 4**
 **22607 Hamburg (DE)**

(56) References cited:
 **EP-A- 0 118 031**   **EP-A- 1 059 329**
 **US-A- 6 143 816**

## Description

### BACKGROUND

Epoxy resins which have been partially reacted (advanced) with a reactive organophosphorus compound are known to have reduced flammability compared to the base resin. Heretofore alumina trihydrate (ATH) has been used as a filler in certain advanced epoxy resins to improve the properties of laminates and printed wiring boards produced from such resins.

While such formulated flame retardant resins are satisfactory in a number of respects, a need exists for new formulated epoxy resins which have been partially reacted with a reactive organophosphorus compound, which formulated resins have greater thermal stability than corresponding resins with which alumina trihydrate has been blended, especially if the improved thermal stability could be achieved without significant loss of flame retardancy and without significant increase in cost. This invention is deemed to fulfill this need.

As is known in the art, epoxy resins can be modified by reaction with various different kinds of compounds containing an active hydrogen atom. This invention is concerned only with epoxy resins which have been partially reacted with a reactive organophosphorus compound. Such reactive organophosphorus compound contains an active hydrogen atom that is (i) attached directly to phosphorus in a dialkyl phosphonate, diaryl phosphonate, dialkyl phosphite, diaryl phosphite, or diaryl phosphine; (ii) attached to an oxygen atom which is attached directly to phosphorus (e.g., a phosphinic acid, dialkylphosphate, or diarylphosphate); or (iii) is in a substituent (e.g., a hydroxyl group) which is attached to an aromatic ring and is activated thereby, and which aromatic ring is bound to phosphorus. Thus, for convenience, the term "epoxy resin advanced with phosphorus" is used to denote a curable epoxy resin composition formed by partially reacting an epoxy resin with a co-reactive organophosphorus compound that contains an active hydrogen atom, which active hydrogen atom is attached either directly to phosphorus or is in a substituent which is attached to an aromatic ring and the hydrogen atom in the substituent is activated by the aromatic ring. Similarly, the term "epoxy resins advanced with phosphorus" refers to more than one such epoxy resin advanced with phosphorus.

### BRIEF SUMMARY OF THIS INVENTION

Pursuant to this invention boehmite (alumina monohydrate) when used with a typical epoxy resin advanced with phosphorus makes it possible to improve thermal stability and to increase the ignition time of laminates formed from prepregs made using this fortified resin. Such laminates have exceptionally high thermal stability and showed similar longer times to ignition as compared to corresponding resins in which alumina trihydrate was used.

Among the embodiments of this invention is an epoxy-containing formulation (*a.k.a.* an "A-stage formulation") from which an epoxy resin advanced with phosphorus can be formed, and into which formulation boehmite was introduced at an appropriate stage before, during, and/or after the remainder of the formulation was formed. Another embodiment is an epoxy resin advanced with phosphorus into which boehmite was introduced at an appropriate stage before, during, and/or after the formation of the remainder of the resin formulation. A further embodiment is a method of forming a prepreg wherein (i) boehmite is introduced into a formulation from which an epoxy resin advanced with phosphorus can be formed, which addition occurs before, during, and/or after the remainder of the formulation has occurred; (ii) formulation formed in (i) is applied to a suitable substrate to form a coated or impregnated substrate; and (iii) heat is applied to at least one coated or impregnated substrate formed in (ii) to produce a prepreg. Still another embodiment is an improvement in the production of a laminate from a plurality of prepregs in the form of sheets or mats of fibrous substrate coated or impregnated with a formulation comprised of an epoxy resin advanced with phosphorus. The improvement comprises increasing the thermal stability of laminate by introducing a thermal stability-increasing amount of boehmite into the formulation before, during, and/or after the formation of the remainder of the formulation.

The above and other embodiments of this invention will be still further apparent from the ensuing description and appended claims.

### FURTHER DETAILED DESCRIPTION OF THIS INVENTION

The technology for producing epoxy resin advanced with phosphorus and their uses, including their use in forming prepregs, laminates and copper-clad laminates such as electrical laminate circuit boards, is well-known in the art. See for example U.S. Pat. Nos. 5,036,135; 5,364,893; 5,376,453; 5,587,243; 5,759,690; 5,817,736, 6,291,626 B1; 6,291,627 B 1; 6,296,940 B1; 6,353,080 B1; 6,403,220 B1; 6,403,690 B1; 6,486,242 B1; and WO 01/42359 A1 as published in English on June 14, 2001.

A wide variety of organophosphorus compounds can be employed in forming epoxy resins advanced with phosphorus. As noted above, these organophosphorus compounds contain an active hydrogen atom (i) attached directly to phosphorus in a dialkyl phosphonate, diaryl phosphonate, dialkyl phosphite, diaryl phosphite, or diaryl phosphine; (ii) attached to an oxygen atom which is attached directly to phosphorus (e.g., a phosphinic acid, dialkylphosphate, or diarylphosphate); or (iii) is in a substituent (e.g., a hydroxyl group) which is attached to an aromatic ring and is activated thereby, and which aromatic ring is bound to phosphorus. Non-limiting examples of such organophosphorus compounds include diphenylphosphine, ditolylphosphine, bis(3,5-dimethylphenyl)phosphine, bis(2,5-diethylphenyl)phosphine, dinaphthylphosphine, di(biphenylyl)phosphine, phenyltolylphosphine, naphthylphenylphosphine, 4-hydroxyphenyldiphenylphosphine, 4-hydroxyphenyldimethylphosphine, 2-hydroxy-1-naphthyldiethylphosphine, dimethylphosphite, diethylphosphite, dipropylphosphite, dibutylphosphite, diphenylphosphite, dioctylphosphite diphenylphosphate, diphenylphosphinic acid, dibenzylphosphinic acid, dimethylphosphinic acid, dimethylphosphine oxide, diheptylphosphinic acid, dipropylphosphinic acid, phenyltolylphosphinic acid, methoxyphenylphosphinic acid, methylheptylphosphinic acid, ethoxyphenylphosphinic acid, phenylxylylphosphinic acid, diphenylphosphinobenzoic acid, dioctylphosphinic acid, hydroxyphenylphenylphosphinic acid, dioctylphosphate, 6H-dibenz[c,e][1,2]oxaphosphorin-6-oxide, hydroxyphenylphosphinoylbenzoic acid, hydroxyphenyldimethylphosphonate, hydroxyphenyldiethylphosphonate, hydroxyphenyl-dipropyl-phosphonate, dihydroxyphenyldimethylphosphonate, dihydroxyphenyldiethyl-phosphonate, dihyroxyphenyldipropyl-phosphonate, di(hydroxyphenyl)phenylphosphate, di(hydroxyphenyl)methylphosphate, di(hydroxyphenyl)ethylphosphate, 2-(6-oxido-6H-dibenz[c,e][1,2]oxaphosphorin-6-yl-)-1,4-benzenediol, and 2-(6-oxido-6H-methylbenz[c,e][1,2]oxaphosphorin-6-yl)-1,4-benzenediol.

Typical procedures for forming prepregs and laminates for printed wiring boards involve such operations as:

A) An epoxy-containing formulation is applied to or impregnated into a substrate by rolling, dipping, spraying, other known techniques and/or combinations thereof. The substrate is an inorganic or organic reinforcing agent in the form of fibers, fleece, fabric, or textile material, e.g., typically a woven or non-woven fiber mat containing, for instance, glass fibers or paper.
B) The impregnated substrate is "B-staged" by heating at a temperature sufficient to draw off solvent in the epoxy formulation and optionally to partially cure the epoxy formulation, so that the impregnated substrate is dry to the touch and can be handled easily. The "B-staging" step is usually carried out at a temperature of from 90°C to 210°C and for a time of from 1 minute to 15 minutes. The impregnated substrate that results from B-staging is called a "prepreg". The temperature is most commonly 100°C for composites and 130°C to 200°C for electrical laminates.
C) One or more sheets of prepreg are stacked or laid up in alternating layers with one or more sheets of a conductive material, such as copper foil, if an electrical laminate is desired.
D) The laid-up sheets are pressed at high temperature and pressure for a time sufficient to cure the resin and form a laminate. The temperature of this lamination step is usually between 100°C and 230°C, and is most often between 165°C and 190°C. The lamination step may also be carried out in two or more stages, such as a first stage between 100°C and 150°C and a second stage at between 165°C and 190°C. The pressure is usually between 50 N/cm$^2$ and 500 N/cm$^2$. The lamination step is usually carried out for a time of from I minute to 200 minutes, and most often for 45 minutes to 90 minutes. The lamination step may optionally be carried out at higher temperatures for shorter times (such as in continuous lamination processes) or for longer times at lower temperatures (such as in low energy press processes).
E) Optionally, the resulting laminate, for example, a copper-clad laminate, may be post-treated by heating for a time at high temperature and ambient pressure. The temperature of post-treatment is usually between 120°C and 250°C. The post-treatment usually is between 30 minutes and 12 hours.
F) Often an electrically-conductive printed circuit is applied to the copper-clad laminate.

It will be appreciated that the boehmite addition to the formulation used in step A) above can take place before, during and/or after the formation of the remainder of the formulation has occurred. Thus, for example, the boehmite can be added to and dispersed in the solvent before any other component is introduced. Alternatively, the boehmite can be added to and dispersed in the solvent after the addition of one or more of the other components of the formulation. At least during or after the addition of the boehmite, the resultant mixture is subjected to high speed, high shear mixing so that the solid particles are dispersed and suspended in the liquid phase. Preferably this mixing takes place after a suitable surfactant has been introduced into the liquid phase as this will assist in establishing a well-dispersed and suitably-suspended mixture of the solids in the liquid. In this connection, and without desiring to be bound by theory, it is presumed that the solids resulting from the addition of the boehmite to the liquid phase at some appropriate stage are still composed at least in part of boehmite. However, this invention does not require that the boehmite must remain as boehmite in the formulation. Whatever chemical form in which the resultant solids exist in the formulation is within the scope of this invention provided only that the resultant prepreg and laminate ultimately produced from the formulation have increased thermal stability because of the presence of these solids in the formulation used.

The boehmite additive is typically added to the liquid phase in finely-divided particulate or powdery form so that it can be more readily suspended or dispersed in the liquid formulation. However if the amount of shear from the mixer used is high enough to comminute larger particles, larger particles of boehmite can be used as the additive.

Typically, the average particle size of the boehmite additive is in the range of 0.1 to 120 microns, and generally 50 percent by weight of the particles have a particle size of at least 50 microns. Boehmite having an average particle size in the range of 0.1 to 60 microns is preferred. More preferred is boehmite with an average particle size in the range of 0.1 to 30 microns. Boehmite with an average particle size in the range of 0.1 to 10 microns is most preferred, especially when 100 percent by weight of the particles have a particle size of 10 microns or less, 90 percent by weight of the particles have a particle size of 3.3 microns or less, 50 percent by weight of the particles have a particle size of 1.3 microns or less, and 10 percent by weight of the particles have a particle size of 0.6 microns or less.

Amounts of the boehmite additive used in producing the formulations of this invention can be varied depending, for example, upon the amount of thermal stability improvement desired. In general any thermal stability-improving amount of boehmite can be used, and this amount can be readily determined in any given case by conducting a few preliminary laboratory experiments using several different dosage levels and recording the thermal decomposition temperatures of the cured composition. Typically the amount will fall in the range of 5 to 100 phr (exclusive of any other components). More desirably, the amount on a weight basis will usually be in the range of 10 to 50 parts per hundred parts (phr) of epoxy resin (exclusive of any other components). Preferably this amount is in the range of 30 to 50 phr.

A preferred boehmite additive (Martoxal BN-2) for use in the practice of this invention is available commercially from Albemarle Corporation. It has the following typical specifications:

| | |
|---|---|
| $Na_2O$ total | ≤0.10 |
| CaO | ≤0.03 |
| $Fe_2O_3$ | ≤0.03 |
| $SiO_2$ | ≤0.06 |
| Loss on Ignition(%) | 17±2 |
| Specific Surface (BET), $m^2/g$ | 15±5 |
| Bulk Density ($kg/m^3$) | 700 ± 100 |
| Particle Size $d_{50}(\mu m)$ | 1 ± 0.2 |
| Particle Size $d_{100}(\mu m)$ | 10±2 |

Any epoxy resin advanced with phosphorus suitable for use in the formation ofprepregs for making laminates, especially laminates for printed wiring boards and composite materials, can be used in the formulation. Such epoxy resins are preferably preformed, but can be formed in situ by use of a non-phosphorus-containing epoxy resin and a phosphorus-containing compound co-reactive therewith. It is also possible to use a mixture of preformed epoxy resin advanced with phosphorus, a non-phosphorus-containing epoxy resin, and a phosphorus-containing compound co-reactive with the non-phosphorus-containing epoxy resin. The literature such as that cited above and incorporated herein describes a great many different epoxy resins advanced with phosphorus that can be used in the practice of this invention.

An example of one type of epoxy resins advanced with phosphorus that can be used in the formulation, are the resins formed as in U.S. Pat. No. 5,376,453 referred to above and incorporated herein: This type is formed from (i) an aromatic and/or heterocyclic polyepoxide resin free of phosphorus, optionally in admixture with an aliphatic epoxy resin and (ii) an epoxy group containing phosphorus compound such as an alkyl or aryl diglycidyl phosphonate or phosphate. The curing agent used with this type of in situ generated epoxy resin advanced with phosphorus is an aromatic polyamine curing agent such as that prepared by trimerization of a 4:1 mixture of toluene-2,4-diisocyanate and toluene-2,6-diisocyanate followed by hydrolysis yielding a product with an $NH_2$ value of 8.7%.

Another non-limiting example of a type of epoxy resins advanced with phosphorus that can be used in the formulation are the resins formed as in U.S. Pat No. 6,291,626 referred to above and incorporated herein. This type is formed by reacting a linear epoxy resin having two terminal glycidyl groups, with a phosphorus-containing dihydric phenol or naphthol such as 2-(6-oxido-6H-dibenz[c,e] [1,2]oxaphosphorin-6-yl)-1,4-benzenediol.

A further non-limiting example of a type of epoxy resins advanced with phosphorus that can be used in the formulation are the resins formed as in U.S. Pat. No. 6,291,627 referred to above and incorporated herein. This type is formed by reacting a phosphorus-containing compound having an active hydrogen atom connected directly to the phosphorus atom, e. g. , 9,10-dihydro-9-oxa-10-phosphaphenanthrene-10-oxide, with a di- or poly-functional epoxy resin via an addition reaction between the active hydrogen atom and the epoxide group.

Still another-non-limiting example of a type of epoxy resins advanced with phosphorus that can be used in the formulation are the resins formed as in U.S. Pat. No. 6,353,080 referred to above and incorporated herein. This type is formed from specified amounts of (i) an epoxy resin, (ii) a phosphonic acid ester such as an ester of methane phosphonic acid with a glycol or polyol, (iii) a nitrogen-containing cross-linking agent having an amine functionality of at least 2, and (iv) a Lewis acid, such as boric acid. Preferred catalysts for use with this system are benzyldimethylamine, tris(dimethylaminomethyl)phenol, or 2-phenylimidazole.

Yet another non-limiting example of a type of epoxy resins advanced with phosphorus that can be used in the formulation are the resins formed as in U.S. Pat. No. 6,403,220 referred to above and incorporated herein. This type is formed from a curable epoxy resin and tri(o-hydroxyphenyl)phosphine in which, optionally, one or more of the phenyl groups may be substituted by an alkyl group, and thus these ingredients can be either partially pre-reacted and the pre-reacted product introduced into the formulation or the reactants themselves can be introduced into the formulation to form a resin in situ.

A further non-limiting example of a type of epoxy resins advanced with phosphorus that can be used in the formulation is the resins formed as in U.S. Pat. No. 6,486,242 referred to above and incorporated herein. This type is formed from a novolak epoxy resin, a novolak resin, and a phosphorus compound reactable with the epoxy resin or novolak resin, such as 9,10-dihydro-9-oxa-10-phosphaphenanthrene-10-oxide or tris(4-aminophenyl)phosphine oxide.

Still other suitable epoxy resins advanced with phosphorus or the components used to form them will now be apparent to those skilled in the art.

Other components which are desirably introduced into the formulation are one or more surfactants, wetting agents, or dispersants, one or more curatives and one or more promoters for the curative(s).

Among suitable surfactants, wetting agents or dispersants are those that achieve an optimum wet out of the additives such that each individual particle is coated with resin. These are typically available from suppliers such as BYK Chemie and Avecia Additives. The choice of a particular type of surfactant, wetting agent or dispersant depends upon the resin and the desired properties of the laminate or printed wiring board.

While the amounts of the surfactant(s) can vary, typically the amount on a weight basis added to the formulation is in the range of 1 % to 4% of the weight of non-reactive additives, preferably in the range of 1.0% to 2%.

Non-limiting examples of suitable curatives that can be used include m-phenylene diamine, diamino diphenyl sulfone, diaminodiphenylmethane, diamino phenyl triazine, dicyandiamide, and sulfanilamide. Of these dicyandiamide is a preferred curative. Amounts of curative introduced into the formulation is a function of the epoxy equivalent weight (EEW) of the resin, the functionality of the curative, and the molecular weight of the curative. An equation commonly used for calculating a suitable amount of curative to use is as follows:

$$\text{phr curative} = \frac{\text{(curative molecular weight/curative functionality) x 100}}{\text{EEW of resin}}$$

Promoters that can be employed in producing the formulation include, for example, 2-phenylimidazole, benzyldimethylamine, N-methylimidazole, and 2-ethyl-4-methylimidazole. Generally a weight ratio in the range of 4 to 15 parts of curative per part of promoter can be used with a preferred ratio being 15:1.

Often the solvent for the epoxy resin advanced with phosphorus is a ketone such as acetone. However any other suitable type of conventionally-used solvent for forming these formulations can be employed. Examples of such other solvents include methylethyl ketone (MEK), methyl isobutyl ketone (MIBK), 2-methoxy ethanol, 1-methoxy-2-propanol, propylene glycol monomethyl ether, ethylene glycol monoethylether acetate, toluene, N,N-dimethylformamide.

If desired; non-reactive phosphorus flame retardants such as organic phosphates, phosphites, phosphonates, or phosphoramidates and their metal salts, that are free of substituents reactive with epoxy groups may be included in the formulation. Still other optional components which may be included in the formulation include ammonium phosphate, melamine, melamine cyanurate, melamine pyrophosphate, melamine polyphosphate.

The following Examples are illustrative and are not intended to limit the overall scope of this invention to the specific modes and materials used therein. In these Examples the epoxy resin advanced with phosphorus used was a proprietary epoxy novolac resin which had been interacted with a co-reactive organophosphorus compound. This resin is deemed to be a representative example of present-day epoxy resins advanced with phosphorus.

**EXAMPLE 1**

*Preparation of 4-ply and 8-ply Laminates from an Epoxy Resin Advanced with Phosphorus and Boehmite (50 phr).*

A solution of 8g of dicyandiamide (DICY) and 0.52g of 2-methylimidazole (2-MI) in 72g of N,N-dimethylformamide (DMF) is prepared. The solution is combined with 320g of a solution of an epoxy resin advanced with phosphorus (260g resin; EEW = 330) and 2.6g of LP W20037 dispersant (BYK Chemie) in a 1L disposable beaker. To this mixture are added 130g (50 phr) of boehmite (BN-2; Martinswerk GmbH) and 50g of acetone and the resultant mixture is agitated for 30 minutes at 6000 rpm with a Silverson L4RT Laboratory Mixer. The well-dispersed mixture is applied with a paint brush to 13 pieces of 12" x 12" woven glass fiber cloth (designated as 7628 by BGF Industries). Each piece is hung in a well ventilated oven for 3.5 minutes at 170°C, cooled and trimmed to 10" x 10". Each piece was determined to contain 50% resin mixture. Four of the 10" x 10" pieces were stacked one on top of the other and stapled together. Eight of the 10" x 10" pieces were stacked one on top of the other and stapled together. The 4-ply stack was placed on a double sheet of DuPont Tedlar® release film and covered with a double sheet of the same film. The stack was then placed between two metal plates. The 8-ply stack was placed on a double sheet of DuPont Tedlar release film and covered with a double sheet of the same film. The stack was then placed on the metal sheet covering the 4-ply stack. A third metal sheet was then used to cover the top of the 8-ply stacks. The entire "book" was then heated for 60 minutes at 170°C in a Carver press at 21,OOOpsi. The laminates were removed from the press and UL-94 bars were cut using a wet saw. A UL-94 rating of V-0 was obtained with both laminates. Table 1, in which the numerical values are burn duration times after the first and second ignitions, summarizes the data from these tests.

**TABLE 1**

|  | 8-ply | | 8-ply (repeat) | | 4-ply | |
|---|---|---|---|---|---|---|
|  | 1st Ignition | 2nd Ignition | 1st Ignition | 2nd Ignition | 1st Ignition | 2nd Ignition |
| 1 | 2.97 | 0.77 | 4.74 | 7.59 | 8.64 | 3.87 |
| 2 | 2.13 | 0.90 | 0.91 | 1.53 | 4.78 | 3.83 |
| 3 | 0.97 | 2.77 | 2.57 | 6.79 | 4.67 | 3.18 |
| 4 | 1.29 | 1.59 | 0.81 | 1.34 | 6.22 | 1.31 |
| 5 | 2.96 | 23.27 | 1.29 | 3.84 | 4.85 | 4.61 |
| total time | 10.32 | 29.3 | 10.32 | 21.09 | 29.16 | 16.80 |
| rating | V-1 (rerun) | | V-0 (31.41) | | V-0 (45.96) | |

## EXAMPLE 2

*Preparation of Laminates from an Epoxy Resin Advanced with Phosphorus and Boehmite (30 phr).*

The procedure of Example 1 was repeated with the exception that the formulation contained 320g of a solution of an epoxy resin advanced with phosphorus, 8g of DICY, 0.52g of 2-MI, 79.4g of DMF, 2.6g of LPW 20037 dispersant, 78g of boehmite and 14g of acetone. A UL-94 V-0 rating was obtained for both laminates. The data from these tests are summarized in Table 2. As above, the numerical values given are burn duration times in seconds after the first and second ignitions.

**TABLE 2**

|  | 1st Ignition (sec) | 2nd Ignition (sec) | 1st Ignition (sec) | 2nd Ignition (sec) |
|---|---|---|---|---|
| 1 | 1.23 | 4.53 | 4.45 | 5.49 |
| 2 | 0.73 | 7.03 | 8.05 | 1.91 |
| 3 | 1.64 | 1.80 | 4.03 | 4.81 |
| 4 | 2.38 | 4.17 | 4.14 | 0.97 |
| 5 | 2.27 | 6.05 | 4.18 | 1.91 |
| total time | 8.25 | 23.58 | 24.85 | 15.09 |
| rating | V-0(31.83 sec) | | V-0 (39.94 sec) | |

## EXAMPLE 3

*Preparation of Laminates, from an Epoxy Resin Advanced with Phosphorus and Boehmite (10 phr).*

The procedure of Example 1 was again repeated with the exception that the formulation contained 320g of a solution of an epoxy resin advanced with phosphorus, 8g of DICY, 0.52g of 2-MI, 79.4g of DMF, 2.6g of LPW 20037 dispersant, 26g of boehmite and 19g of acetone. A UL-94 V-0 rating was obtained for the 4-ply laminate and a V-1 rating for the 8-ply laminate. Table 3 summarizes the results of these UL-94 tests.

**TABLE 3**

|  | 8-ply | | 4-ply | |
|---|---|---|---|---|
|  | 1st Ignition (sec) | 2nd Ignition (sec) | 1st Ignition (sec) | 2nd Ignition (sec) |
| 1 | 2.25 | 8.07 | 2.82 | 0.88 |
| 2 | 4.29 | 6.93 | 2.60 | 0.89 |
| 3 | 2.65 | 9.47 | 2.03 | 0.89 |
| 4 | 2.67 | 8.13 | 4.03 | 3.32 |
| 5 | 5.73 | 11.15 | 3.08 | 7.60 |
| total time | 17.59 | 43.75 | 14.56 | 13.58 |
| rating | V-1 (61.34 sec) | | V-0 (28.14 see) | |

## COMPARATIVE EXAMPLE A

*Preparation of Laminates from an Epoxy Resin Advanced with Phosphorus*

The procedure of Example 1 was repeated with the exception that the formulation contained only 350g of a solution of an epoxy resin advanced with phosphorus, 8.75g of DICY, 0.57g of 2-MI, and 78.8g of DMF. A UL-94 V-0 rating was obtained for both the 8-ply and the 4-ply laminate. Results of these UL-94 tests are summarized in Table 4.

**TABLE 4**

|  | 1st Ignition (sec) | 2nd Ignition (sec) | 1st Ignition (sec) | 2nd Ignition (sec) |
|---|---|---|---|---|
| 1 | 4.94 | 3.93 | 2.36 | 1.12 |
| 2 | 6.03 | 9.01 | 6.49 | 1.99 |
| 3 | 1.03 | 4.22 | 5.44 | 2.23 |
| 4 | 2.69 | 3.29 | 3.94 | 0.99 |
| 5 | 6.49 | 5.31 | 4.23 | 2.25 |
| total time | 21.21 | 25.76 | 22.46 | 8.58 |
| rating | V-0 (46.97 sec) | | V-0 (31.04 sec) | |

## COMPARATIVE EXAMPLE B

*Preparation of 4-ply and 8-ply laminates from an Epoxy Resin Advanced with Phosphorus and Alumina Trihydrate (50phr).*

A 1 L disposable beaker is charged with a solution containing 320g of a solution of an epoxy resin advanced with phosphorus, 8g of dicyandiamide ("DICY"), 0.52g of 2-methylimidazole ("2-MI") and 72g of N,N-dimethylformamide ("DMF"). To the solution is added 2.6g of LPW 20037 dispersant (BYK Chemie), 130g of alumina trihydrate (TS-601; Martinswerk GmbH.) and 50g of acetone. The mixture is agitated for 30 minutes at 5500-6000 rpm with a Silverson L4RT Laboratory Mixer. The well dispersed mixture is applied with a paint brush to 12 pieces of 12" x 12" BGF Industries 7628 woven glass fiber cloth. Each piece is hung in a well-ventilated oven for 3.5 minutes at 170°C, cooled and trimmed to 10" x 10". Each piece was determined to contain 50% resin mixture. Four of the 10" x 10" pieces were stacked one on top of the other and stapled together. Eight of the 10" x 10" pieces were stacked one on top of the other and stapled together. The 4-ply stack was placed on a double sheet of DuPont Tedlar release film and covered with a double sheet of the same film. The stack was then placed between two metal plates. The 8-ply stack was placed on a double sheet of DuPont Tedlar release film and covered with a double sheet of the same film. The stack was then placed on the metal sheet covering the 4-ply stack. A third metal sheet was then used to cover the top of the 8-ply stacks. The entire "book" was then heated for 60 minutes at 170°C in a Carver press at 21,OOOpsi. The laminates were removed from the press

7

and UL-94 bars were cut using a wet saw. A UL-94 rating of V-0 was obtained with both laminates. Table 5 summarizes the results of these UL-94 tests.

**TABLE 5**

| | 8-ply | | 4-ply | |
|---|---|---|---|---|
| | 1 st Ignition | 2nd Ignition | 1st Ignition | 2nd Ignition |
| 1 | 0.77 | 3.01 | 0.89 | 3.70 |
| 2 | 0.76 | 1.17 | 1.09 | 4.82 |
| 3 | 0.73 | 0.91 | 0.76 | 2.50 |
| 4 | 0.87 | 0.83 | 1.63 | 4.92 |
| 5 | 0.79 | 0.93 | 1.17 | 3.69 |
| total time | 3.92 | 6.85 | 5.54 | 19.63 |
| rating | V-0 (10.14 sec) | | V-0 (25.17 sec) | |

**EXAMPLE 4**

Comparative experiments were carried out to ascertain the thermal stabilities of several different laminates. In these experiments comparisons among laminates prepared from (i) the additive-free base resin of Comparative Example A, (ii) the same additive-free base resin with which had been blended 50 phr of alumina trihydrate (TS-601), and (iii) the same additive-free base resin with which had been blended 50 phr of boehmite (Martoxal BN-2). The results of these thermal stability determinations are summarized in Table 6.

**TABLE 6**

| Laminate | Temperature (°C) Required for 5% Weight Loss |
|---|---|
| Base Resin (Comparative Example A) | 372 |
| Base Resin plus TS-601 (Comparative Example B) | 358 |
| Base Resin plus Boehmite | 391 |

It will be seen that in contrast to addition of alumina trihydrate which reduced the thermal stability of the composition, the use pursuant to this invention of boehmite resulted in a significant increase in thermal stability.

Compounds referred to by chemical name or formula anywhere in this document, whether referred to in the singular or plural, are identified as they exist prior to coming into contact with another substance referred to by chemical name or chemical type (e.g., another component, a solvent). It matters not what chemical changes, if any, take place in the resulting mixture or solution, as such changes are the natural result of bringing the specified substances together under the conditions called for pursuant to this disclosure.

Also, even though the claims may refer to substances in the present tense (e.g., "comprises", "is"), the reference is to the substance as it exists at the time just before it is first contacted, blended or mixed with one or more other substances in accordance with the present disclosure.

Except as may be expressly otherwise indicated, the article "a" or "an" if and as used herein is not intended to limit, and should not be construed as limiting, the description or a claim to a single element to which the article refers. Rather, the article "a" or "an" if and as used herein is intended to cover one or more such elements, unless the text expressly indicates otherwise.

**Claims**

1.   A substantially halogen-free epoxy resin formulation suitable for coating or impregnating a substrate said epoxy resin being an epoxy resin advanced with phosphorous and having dispersed in said formulation a thermal stability increasing amount of a finely-divided boehmite.

2.   A formulation as in Claim 1 wherein said amount is in the range of 10 to 50 phr exclusive of other components in the formulation.

3. A formulation as in Claim 1 wherein said amount is in the range of 30 to 50 phr exclusive of other components in the formulation.

4. A composition suitable for forming a prepreg, said composition comprising inorganic or organic reinforcing agent in the form of fibers, fleece, fabric, or textile material impregnated and/or coated with a formulation as in any of Claims 1 -3.

5. A composition as in Claim 4 wherein said reinforcing agent is in the form of a fabric or textile material.

6. A composition as in Claim 4 wherein said composition is in the form of a woven or non-woven fiber mat comprised of glass fibers.

7. A prepreg formed from a composition of Claim 4.

8. A prepreg formed from a composition of Claim 5.

9. A prepreg formed from a composition of Claim 6.

10. A composite material formed from a composition of Claim 5.

11. A printed-circuit board formed from a composition of Claim 6.

12. A laminate formed from a composition of Claim 4.

13. A method of forming a prepreg having increased thermal stability, which method comprises:

A) applying to and/or impregnating an inorganic or organic reinforcing agent in the form of fibers, fleece, fabric, or textile material with an epoxy resin formulation said epoxy resin being an epoxy resin advanced with phosphorus which includes a solvent, and to which has been added before, during and/or after formation of the formulation, a thermal stability-increasing amount of boehmite and in which formulation the solids have been dispersed and/or suspended, to thereby form a coated or impregnated sheet-like substrate; and
B) heating substrate formed in A) at a temperature sufficient to draw off solvent from the formulation and optionally to partially cure the epoxy formulation, so that a prepreg that can be handled easily is formed from such impregnated substrate.

14. A method of forming a laminate having increased thermal stability, which method comprises:

A) applying to and/or impregnating an inorganic or organic reinforcing agent in the form of a mat of woven or unwoven fibers, fleece, fabric, or textile material of which includes a solvent, and to which has been added before, during and/or after formation of the formulation, a thermal stability-increasing amount of boehmite and in which formulation the solids have been dispersed and/or, suspended, to thereby form a coated or impregnated sheet-like substrate;
B) heating substrate formed in A) at a temperature sufficient to draw off solvent from the formulation and optionally to partially cure the epoxy formulation, so that a sheet-like prepreg that can be handled easily is formed from such impregnated substrate;
C) forming a stack comprised of a plurality of sheet-like prepregs formed in B); and
D) pressing a stack formed in C) at high temperature and pressure for a time sufficient to cure the resin and form a laminate.

15. A method as in Claim 14 wherein said stack is further comprised of one or more sheets of an electrically-conductive material to form an electrical laminate.

16. A method as in Claim 14 wherein an electrically-conductive printed circuit is applied to said laminate.

17. A method as in any of Claims 13-16 wherein said thermal stability-increasing amount-is in the range of 10 to 50 phr exclusive of other components in the formulation.

**18.** A method as in any of Claims 13-16 wherein said thermal stability-increasing amount is in the range of 30 to 50 phr, exclusive of other components in the formulation.

**Patentansprüche**

**1.** Im Wesentlichen halogenfreie Epoxyharz-Formulierung, die für eine Beschichtung oder Imprägnierung eines Substrats geeignet ist, wobei das Epoxyharz ein Epoxyharz ist, das mit Phosphor weiterbehandelt worden ist, wobei in der Formulierung eine die thermische Stabilität steigernde Menge von feinteiligem Boehmit dispergiert vorliegt.

**2.** Formulierung nach Anspruch 1, bei der die Menge im Bereich von 10 bis 50 phr liegt, ausschließlich der anderen Komponenten in der Formulierung.

**3.** Formulierung nach Anspruch 1, bei der die Menge im Bereich von 30 bis 50 phr liegt, ausschließlich der anderen Komponenten in der Formulierung.

**4.** Zusammensetzung, die zur Bildung eines Prepregs geeignet ist, wobei die Zusammensetzung anorganische oder organische Verstärkungsmittel in Form von Fasern, Vlies, Gewebe oder Textilmaterial, imprägniert und/oder beschichtet mit einer Formulierung gemäß einem der Ansprüche 1 bis 3, umfasst.

**5.** Zusammensetzung nach Anspruch 4, bei der das Verstärkungsmittel in Form eines Gewebes oder Textilmaterials vorliegt.

**6.** Zusammensetzung nach Anspruch 4, bei der die Zusammensetzung in Form einer gewebten Fasermatte oder einer Vliesfasermatte vorliegt, die aus Glasfasern zusammengesetzt sind.

**7.** Prepreg, das aus einer Zusammensetzung gemäß Anspruch 4 gebildet worden ist.

**8.** Prepreg, das aus einer Zusammensetzung gemäß Anspruch 5 gebildet worden ist.

**9.** Prepreg, das aus einer Zusammensetzung gemäß Anspruch 6 gebildet worden ist.

**10.** Verbundmaterial, das aus einer Zusammensetzung gemäß Anspruch 5 gebildet worden ist.

**11.** Platine, die aus einer Zusammensetzung gemäß Anspruch 6 gebildet worden ist.

**12.** Laminat, das aus einer Zusammensetzung gemäß Anspruch 4 gebildet worden ist.

**13.** Verfahren zur Bildung eines Prepregs mit gesteigerter thermischer Stabilität, wobei das Verfahren umfasst:

(A) Aufbringen auf und/oder Imprägnieren eines anorganischer oder organischen Verstärkungsmittels in Form von Fasern, Vlies, Gewebe oder Textilmaterial mit einer Epoxyharz-Formulierung, wobei die Epoxyharz-Formulierung ein Epoxyharz ist, das mit Phosphor weiterbehandelt worden ist und Lösungsmittel enthält und zu dem vor, während und/oder nach der Bildung der Formulierung eine die thermische Stabilität steigernde Menge Boehmit gegeben worden ist, wobei die Feststoffe in der Formulierung dispergiert und/oder suspendiert worden sind, um **dadurch** ein beschichtetes oder imprägniertes blatt-/plattenartiges Substrat zu bilden; und
(B) Erhitzen des in A) gebildeten Substrats auf eine Temperatur, die ausreicht, um Lösungsmittel aus der Formulierung abzuziehen und die Epoxyformulierung gegebenenfalls partiell zu härten, so dass aus einem solchen imprägnierten Substrat ein Prepreg gebildet wird, das leicht gehandhabt werden kann.

**14.** Verfahren zur Bildung eines Laminats mit gesteigerter thermischer Stabilität, wobei das Verfahren umfasst:

(A) Aufbringen auf und/oder Imprägnieren eines anorganischer oder organischen Verstärkungsmittels in Form einer Matter aus gewebten oder ungewebten Fasern, Vlies, Gewebe oder Textilmaterial mit einer Epoxyharz-Formulierung, wobei die Epoxyharz-Formulierung ein Epoxyharz ist, das mit Phosphor weiterbehandelt worden ist und Lösungsmittel enthält und zu dem vor, während und/oder nach der Bildung der Formulierung eine die thermische Stabilität steigernde Menge Boehmit gegeben worden ist, wobei die Feststoffe in der Formulierung dispergiert und/oder suspendiert worden sind, um **dadurch** ein beschichtetes oder imprägniertes blatt-/plattenartiges Substrat zu bilden;

(B) Erhitzen des in A) gebildeten Substrats auf eine Temperatur, die ausreicht, um Lösungsmittel aus der Formulierung abzuziehen und die Epoxyformulierung gegebenenfalls partiell zu härten, so dass aus einem solchen imprägnierten Substrat ein blatt-/plattenartiges Prepreg gebildet wird, das leicht gehandhabt werden kann;

(C) Bilden eines Stapels, der aus einer Vielzahl von blatt/plattenartigen in B) gebildeten Prepregs zusammengesetzt ist, und

(D) Pressen eines in C) gebildeten Stapels bei hoher Temperatur und hohem Druck für einen Zeitraum, der ausreicht, um das Harz zu härten und ein Laminat zu bilden.

**15.** Verfahren nach Anspruch 14, bei dem der Stapel ferner aus einer oder mehreren Blättern/Platten aus elektrisch leitfähigem Material zusammengesetzt ist, um ein elektrisches Laminat zu bilden.

**16.** Verfahren nach Anspruch 14, bei dem eine elektrisch leitfähige, gedruckte Schaltung auf das Laminat aufgebracht wird.

**17.** Verfahren nach einem der Ansprüche 13 bis 16, bei dem die die thermische Stabilität steigernde Menge im Bereich von 10 bis 50 phr liegt, ausschließlich der anderen Komponenten in der Formulierung.

**18.** Verfahren nach einem der Ansprüche 13 bis 16, bei dem die die thermische Stabilität steigernde Menge im Bereich von 30 bis 50 phr liegt, ausschließlich der anderen Komponenten in der Formulierung.

**Revendications**

**1.** Formulation de résine époxy essentiellement sans halogène appropriée pour le revêtement ou l'imprégnation d'un substrat, ladite résine époxy étant une résine époxy améliorée avec du phosphore et ayant dispersée dans ladite formulation une quantité augmentant la stabilité thermique d'une boehmite finement divisée.

**2.** Formulation selon la revendication 1 dans laquelle ladite quantité est comprise dans la gamme de 10 à 50 ppc à l'exclusion d'autres composants dans la formulation.

**3.** Formulation selon la revendication 1 dans laquelle ladite quantité est comprise dans la gamme de 30 à 50 ppc à l'exclusion d'autres composants dans la formulation.

**4.** Composition appropriée pour la formation d'un pré-imprégné, ladite composition comprenant un agent de renforcement inorganique ou organique sous la forme de fibres, de nappe, de tissu, ou de matériau textile imprégné et/ou revêtu avec une formulation selon l'une quelconque des revendications 1 à 3.

**5.** Composition selon la revendication 4 dans laquelle ledit agent de renforcement est sous la forme d'un tissu ou d'un matériau textile.

**6.** Composition selon la revendication 4 dans laquelle ladite composition est sous la forme d'un mat de fibres tissées ou non-tissés composées de fibres de verre.

**7.** Pré-imprégné formé à partir d'une composition selon la revendication 4.

**8.** Pré-imprégné formé à partir d'une composition selon la revendication 5.

**9.** Pré-imprégné formé à partir d'une composition selon la revendication 6.

**10.** Matériau composite formé à partir d'une composition selon la revendication 5.

**11.** Carte de circuits imprimés formée à partir d'une composition selon la revendication 6.

**12.** Stratifié formé à partir d'une composition selon la revendication 4.

**13.** Procédé de formation d'un pré-imprégné ayant une stabilité thermique augmentée, lequel procédé comprend :

A) l'application et/ou l'imprégnation d'un agent de renforcement inorganique ou organique sous la forme de fibres, de nappe, de tissu, ou de matériau textile avec une formulation de résine époxy, ladite formulation de résine époxy étant une résine époxy améliorée avec du phosphore qui comprend un solvant, et à laquelle a été ajouté avant, pendant et/ou après la formation de la formulation, une quantité augmentant la stabilité thermique de boehmite et dans laquelle formulation les particules solides ont été dispersées et/ou mises en suspension, pour former ainsi un substrat en forme de feuille revêtu ou imprégné; et

B) le chauffage du substrat formé en A) à une température suffisante pour éliminer le solvant de la formulation et éventuellement pour durcir partiellement la formulation époxy, afin qu'un pré-imprégné qui peut être manipulé facilement soit formé à partir d'un tel substrat imprégné.

**14.** Procédé de formation d'un stratifié ayant une stabilité thermique augmentée, lequel procédé comprend :

A) l'application et/ou l'imprégnation d'un agent de renforcement inorganique ou organique sous la forme d'un mat de fibres tissées ou non-tissées, de nappe, de tissu, ou de matériau textile avec une formulation de résine époxy, ladite formulation de résine époxy étant une résine époxy améliorée avec du phosphore qui comprend un solvant, et à laquelle a été ajouté avant, pendant et/ou après la formation de la formulation, une quantité augmentant la stabilité thermique de boehmite et dans laquelle formulation les particules solides ont été dispersées et/ou mise en suspension, pour former ainsi un substrat en forme de feuille revêtu ou imprégné ;

B) le chauffage du substrat formé en A) à une température suffisante pour éliminer le solvant de la formulation et éventuellement pour durcir partiellement la formulation époxy, afin qu'un pré-imprégné en forme de feuille qui peut être facilement manipulé soit formé à partir d'un tel substrat imprégné ;

C) la formation d'un empilement composé d'une pluralité de pré-imprégnés en forme de feuille formé en B) ; et

D) Le pressage d'un empilement formé en C) à température et pression élevées pendant un temps suffisant pour durcir la résine et former un stratifié.

**15.** Procédé selon la revendication 14 dans lequel ledit empilement est en outre composé d'une ou plusieurs feuilles d'un matériau électroconducteur pour former un stratifié électrique.

**16.** Procédé selon la revendication 14 dans lequel un circuit imprimé électroconducteur est appliqué audit stratifié.

**17.** Procédé selon l'une quelconque des revendications 13 à 16 dans lequel ladite quantité augmentant la stabilité thermique est comprise dans la gamme de 10 à 50 ppc à l'exclusion d'autres composants dans la formulation.

**18.** Procédé selon l'une quelconque des revendications 13 à 16 dans lequel ladite quantité augmentant la stabilité thermique est comprise dans la gamme de 30 à 50 ppc, à l'exclusion d'autres composés dans la formulation.